# EUROPEAN PATENT APPLICATION

(11) **EP 4 033 536 A1**
(43) Date of publication of application: **27.07.2022**
(21) Application number: 19946229.2
(22) Date of filing: 18.09.2019
(51) Int. Cl.: H01L 27/15, H01L 33/00

(54) **DISPLAY DEVICE USING MICRO LED, AND MANUFACTURING METHOD THEREFOR**

(71) Applicant: LG Electronics Inc., SEOUL 07336 (KR)
(72) Inventor: KIM, Myoungsoo, Seoul 06772 (KR); MOON, Sunghyun, Seoul 06772 (KR); KO, Jisoo, Seoul 06772 (KR); KIM, Jungsub, Seoul 06772 (KR); SHIM, Bongchu, Seoul 06772 (KR); CHANG, Wonjae, Seoul 06772 (KR)
(74) Representative: Vossius & Partner Patentanwälte Rechtsanwälte mbB
(86) International application number: PCT/KR2019/012065
(87) International publication number: WO 2021/054491

(57) **Abstract**

The present specification provides a semiconductor light-emitting device assembled on a substrate in a specific direction in fluid, and thus can improve assembly speed and assembly precision of the semiconductor light-emitting device. A semiconductor light-emitting device according to one embodiment of the present invention comprises: a semiconductor light-emitting structure having a first conductive semiconductor layer, an active layer, and a second conductive semiconductor layer; and an uneven structure positioned below the first conductive semiconductor layer. The uneven structure acts as an assembly blocking layer during assembly, thereby preventing, on one surface having the uneven structure, the semiconductor light-emitting device from being assembled on the assembly substrate.

## Description

### TECHNICAL FIELD

The present disclosure is applicable to the display device related technical fields, and relates to a display device using micro-Light Emitting Diode (LEDs) and a manufacturing method thereof.

### BACKGROUND ART

Recently, in a field of a display technology, display devices having excellent characteristics such as thinness, flexibility, and the like have been developed. On the other hand, currently commercialized major displays are represented by a LCD (liquid crystal display) and an OLED (organic light emitting diode).

However, the LCD has a response time that is not fast, and is difficult to be flexibly implemented.

On the other hand, LED (light emitting diode), which is a well-known semiconductor light-emitting element that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light-emitting element may be proposed. Such light emitting diode has various advantages, such as long lifespan, low power consumption, excellent initial driving characteristics, high vibration resistance, and the like, compared to a filament-based light-emitting element.

In order to implement a display device using these light-emitting elements, a very large number of semiconductor light-emitting elements is required. Further, in order to implement a large-scale display device, semiconductor light-emitting elements formed on growth substrates need to be individually separated therefrom, and then to be transferred to or assembled on a large-scale display panel.

Further, during such a transfer or assembly process, the semiconductor light-emitting elements need to be accurately arranged in the same direction so as to allow a subsequent metallization process to be smoothly performed.

Accordingly, the present disclosure suggests a new type of semiconductor light-emitting element which is self-assembled in a specific direction, and a display device using the same.

### DISCLOSURE

### TECHNICAL TASK

One task of the present disclosure is to provide a display device using a semiconductor light emitting element and a manufacturing method thereof.

Another task of the present disclosure is to provide a new type of semiconductor light emitting element which is self-assembled in a specific direction in fluid.

Yet another task of the present disclosure is to solve various problems not mentioned herein. Those skilled in the art may understand it through the full text of the specification and drawings.

### TECHNICAL SOLUTIONS

In order to accomplish the above and other tasks, a manufacturing method of a display device using a semiconductor light emitting element according to one aspect of the present invention includes forming the semiconductor light emitting element including an assembly blocking layer formed on one surface thereof, preparing an assembly substrate including an assembly recess configured such that the semiconductor light emitting element is assembled therewith, putting the semiconductor light emitting element into a chamber filled with a fluid, locating the assembly substrate on an upper surface of the chamber, and assembling the semiconductor light emitting element with the assembly recess of the assembly substrate using a magnetic field and an electric field, and transferring the semiconductor light emitting element assembled on the assembly substrate to a wiring substrate.

The forming the semiconductor light emitting element may include forming a stack structure by sequentially stacking an etching layer, an etching protection layer, a first conductivity-type semiconductor layer, an active layer and a second conductivity-type semiconductor layer on a growth substrate, performing isolation to expose some regions of the etching layer of the stack structure, in order to individually define the semiconductor light emitting element, forming conductivity-type electrodes conductively connected to the first conductivity-type semiconductor layer and the second conductivity-type semiconductor layer of the isolated semiconductor light emitting element, forming a passivation layer configured to surround an outer surface of the semiconductor light emitting element, forming an etching electrode on a part of the exposed regions of the etching layer on the growth substrate, and separating the semiconductor light emitting element from the growth substrate through electrochemical etching, and forming an assembly blocking layer on a surface of the semiconductor light emitting element separated from the growth substrate.

The forming the assembly blocking layer may include separating the etching layer into a first etching layer remaining on a lower surface of the etching protection layer and a second etching layer remaining on the growth substrate through the electrochemical etching.

The assembly blocking layer may include the first etching layer, and the first etching layer may have an uneven structure.

An average surface roughness value of the assembly blocking layer may be equal to or greater than an effective distance value of dielectrophoresis force acting in the assembling the semiconductor light emitting element with the assembly recess.

The forming the assembly blocking layer may include forming the uneven structure of the assembly blocking layer in a specific pattern by applying a pulse signal to the etching electrode.

The pattern may be configured such that prominences of the uneven structure extend to form a plurality of bands in a direction from a center of a surface of the assembly blocking layer towards an edge thereof.

A distance between the plurality of bands may be determined depending on an on time and an off time of the pulse signal.

The assembling the semiconductor light emitting element with the assembly recess may include placing a remaining surface of the semiconductor light emitting element opposite to the surface thereof provided with the assembly blocking layer formed thereon on the assembly recess.

The etching layer and the etching protection layer may be an identical semiconductor type with the second conductivity-type semiconductor layer.

A concentration of impurities in the etching layer may be greater than a concentration of impurities in the etching protection layer.

The forming the stack structure may include forming a buffer layer between the growth substrate and the etching layer.

A display device using a semiconductor light emitting element according to another aspect of the present disclosure includes a substrate, an adhesive layer located on the substrate, and the semiconductor light emitting element located on the adhesive layer and configured such that a contact surface between the semiconductor light emitting element and the adhesive layer has an uneven structure, wherein the uneven structure is configured such that prominences of the uneven structure extend to form a plurality of bands in a direction from a center of the contact surface towards an edge thereof.

The semiconductor light emitting element may include a semiconductor light emitting structure including a first conductivity-type semiconductor layer, an active layer and a second conductivity-type semiconductor layer, and the uneven structure located under the first conductivity-type semiconductor layer, and the uneven structure may include a first region and a second region disposed between the first region and the first conductivity-type semiconductor layer, and a concentration of impurities in the first region is greater than a concentration of impurities in the second region.

### ADVANTAGEOUS EFFECTS

According to one embodiment of the present disclosure, a display device using a semiconductor light emitting element and a manufacturing method thereof may be provided.

Specifically, semiconductor light emitting elements including an assembly blocking layer provided on one surface thereof through electromechanical etching are assembled on an assembly substrate. The semiconductor light emitting elements may be assembled on the assembly substrate in fluid using only the other surface thereof, thereby being capable of improving assembly speed and assembly accuracy.

Furthermore, according to another embodiment of the present disclosure, additional effects not mentioned herein may be exhibited. Those of ordinary skill in the art may understand it through the full text of the specification and drawings.

### DESCRIPTION OF DRAWINGS

FIG. 1 is a conceptual diagram illustrating an embodiment of a display device using a semiconductor light emitting element according to the present disclosure.
FIG. 2 is a partially enlarged diagram showing a part A shown in FIG. 1.
FIGs. 3A and 3B are cross-sectional diagrams taken along the cutting lines B-B and C-C in FIG. 2.
FIG. 4 is a conceptual diagram illustrating the flip-chip type semiconductor light emitting element of FIG. 3.
FIGs. 5A to 5C are conceptual diagrams illustrating various examples of color implementation with respect to a flip-chip type semiconductor light emitting element.
FIG. 6 shows cross-sectional views of a method of fabricating a display device using a semiconductor light emitting element according to the present disclosure.
FIG. 7 is a perspective diagram of a display device using a semiconductor light emitting element according to another embodiment of the present disclosure.
FIG. 8 is a cross-sectional diagram taken along a cutting line D-D shown in FIG. 8.
FIG. 9 is a conceptual diagram showing a vertical type semiconductor light emitting element shown in FIG. 8.
FIG. 10 is a flowchart schematically representing a method for manufacturing a display device using semiconductor light emitting elements.
FIG. 11 is a diagram illustrating one embodiment of a method for assembling semiconductor light emitting elements on a substrate through a self-assembly process.
FIG. 12 is an enlarged diagram illustrating a part E shown in FIG. 11.
FIG. 13 is a flowchart schematically representing a method for manufacturing a display device using semiconductor light emitting elements according to the present disclosure.
FIG. 14 is a flowchart schematically representing a method for manufacturing the semiconductor light emitting elements according to the present disclosure on a growth substrate.
FIG. 15 shows cross-sectional diagrams illustrating the method for manufacturing the semiconductor light emitting elements according to the present disclosure on the growth substrate.
FIG. 16 is a diagram illustrating an electrochemical etching method according to the present disclosure.
FIG. 17 shows diagrams illustrating structures of semiconductor light emitting elements according to embodiments of the present disclosure.
FIG. 18 shows SEM images representing the cross-section of a semiconductor light emitting element including an assembly blocking layer.
FIG. 19 shows SEM images representing assembly blocking layers of a semiconductor light emitting element formed by electrochemical etching.
FIG. 20 shows images of the surfaces of the assembly blocking layers of FIG. 19, acquired by a laser microscope.
FIG. 21 is a cross-sectional diagram illustrating a semiconductor light emitting element assembled on an assembly substrate by self-assembly.
FIG. 22 shows cross-sectional diagrams illustrating a process of transferring the semiconductor light emitting element assembled on the assembly substrate to a wiring substrate.

### BEST MODE FOR DISCLOSURE

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting element mentioned in this specification is a concept including an LED, a micro LED, and the like, and may be used interchangeably therewith.

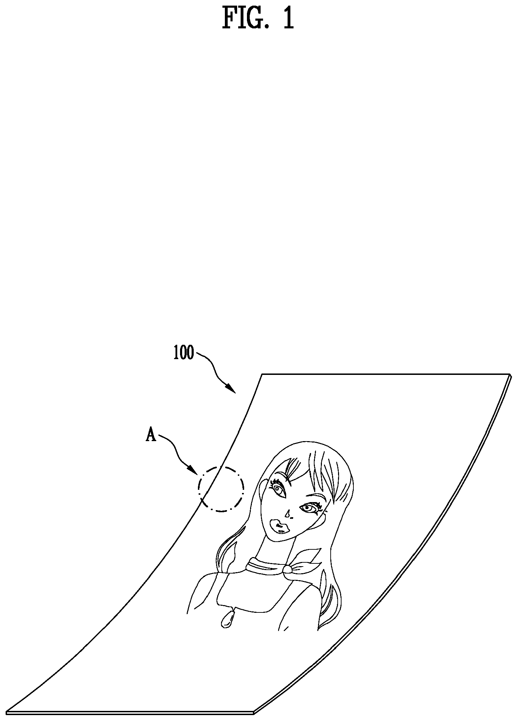

FIG. 1 is a conceptual view illustrating an embodiment of a display device using a semiconductor light emitting element according to the present disclosure.

As shown in FIG. 1, information processed by a controller (not shown) of a display device 100 may be displayed using a flexible display.

The flexible display may include, for example, a display that can be warped, bent, twisted, folded, or rolled by external force.

Furthermore, the flexible display may be, for example, a display manufactured on a thin and flexible substrate that can be warped, bent, folded, or rolled like paper while maintaining the display characteristics of a conventional flat panel display.

When the flexible display remains in an unbent state (e.g., a state having an infinite radius of curvature) (hereinafter referred to as a first state), the display area of the flexible display forms a flat surface. When the display in the first sate is changed to a bent state (e.g., a state having a finite radius of curvature) (hereinafter referred to as a second state) by external force, the display area may be a curved surface. As shown in FIG. 1, the information displayed in the second state may be visual information output on a curved surface. Such visual information may be implemented by independently controlling the light emission of subpixels arranged in a matrix form. The unit pixel may mean, for example, a minimum unit for implementing one color.

The unit pixel of the flexible display may be implemented by a semiconductor light emitting element. In the present disclosure, a light emitting diode (LED) is exemplified as a type of the semiconductor light emitting element configured to convert electric current into light. The LED may be formed in a small size, and may thus serve as a unit pixel even in the second state.

Hereinafter, a flexible display implemented using the LED will be described in more detail with reference to the drawings.

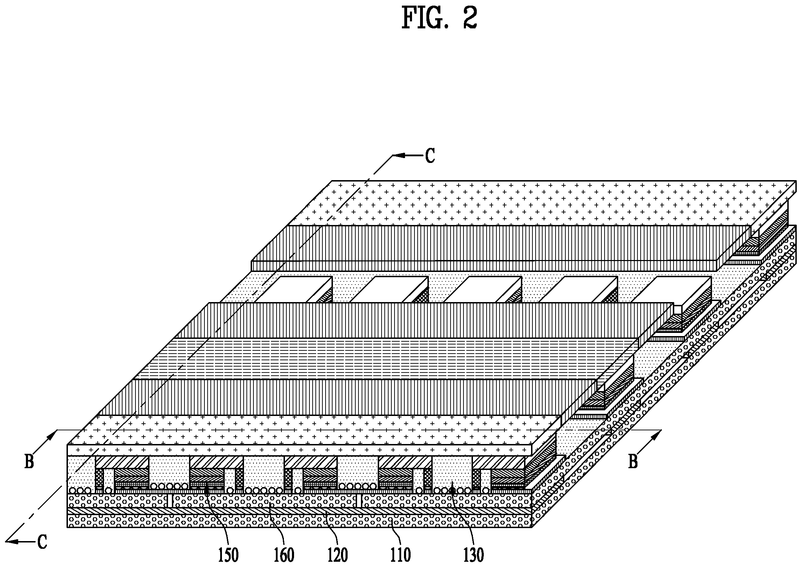

FIG. 2 is a partially enlarged view showing part A of FIG. 1.

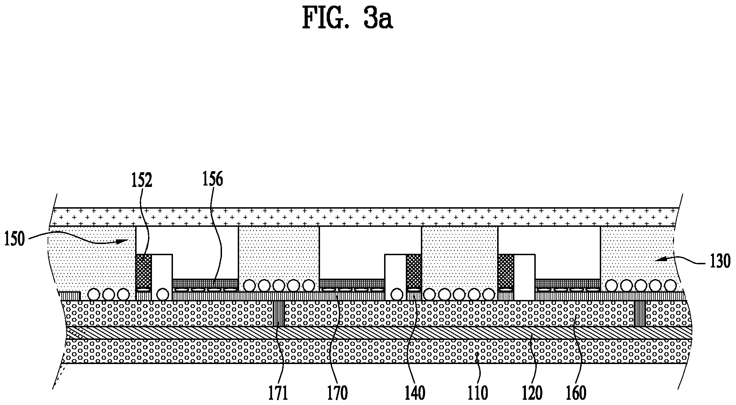

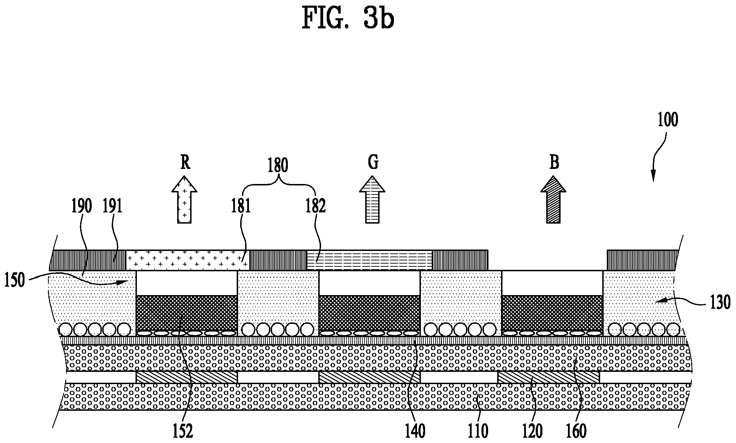

FIGS. 3A and 3B are cross-sectional views taken along lines B-B and C-C in FIG. 2.

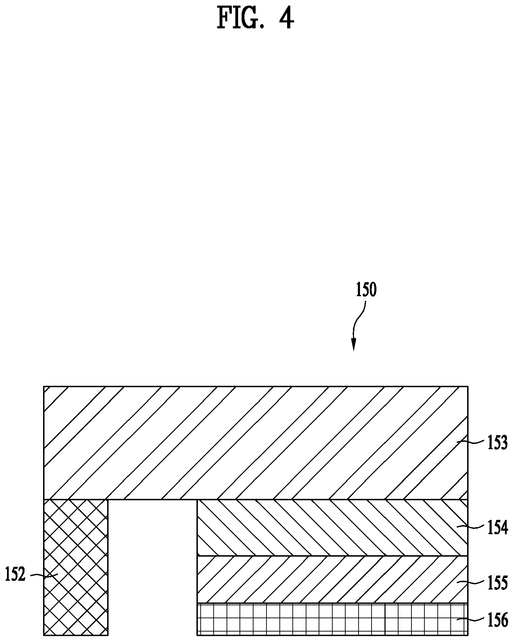

FIG. 4 is a conceptual view illustrating the flip-chip type semiconductor light emitting element of FIG. 3.

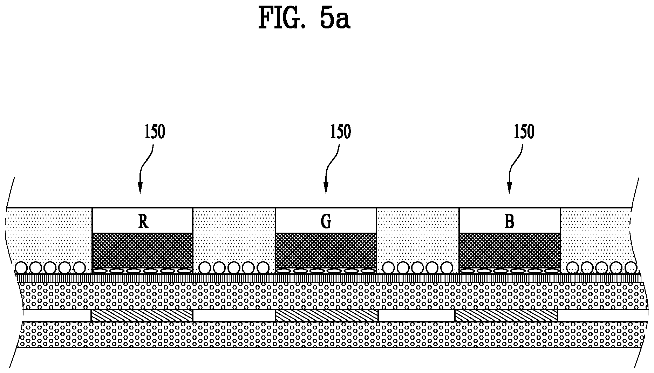

FIGS. 5A to 5C are conceptual views illustrating various examples of implementation of colors in relation to a flip-chip type semiconductor light emitting element.

As shown in FIGS. 2, 3A and 3B, the display device 100 using a passive matrix (PM) type semiconductor light emitting element is exemplified as the display device 100 using a semiconductor light emitting element. However, the examples described below are also applicable to an active matrix (AM) type semiconductor light emitting element.

The display device 100 shown in FIG. 1 may include a substrate 110, a first electrode 120, a conductive adhesive layer 130, a second electrode 140, and at least one semiconductor light emitting element 150, as shown in FIG. 2.

The substrate 110 may be a flexible substrate. For example, to implement a flexible display device, the substrate 110 may include glass or polyimide (PI). Any insulative and flexible material such as polyethylene naphthalate (PEN) or polyethylene terephthalate (PET) may be employed. In addition, the substrate 110 may be formed of either a transparent material or an opaque material.

The substrate 110 may be a wiring substrate on which the first electrode 120 is disposed. Thus, the first electrode 120 may be positioned on the substrate 110.

As shown in FIG. 3A, an insulating layer 160 may be disposed on the substrate 110 on which the first electrode 120 is positioned, and an auxiliary electrode 170 may be positioned on the insulating layer 160. In this case, a stack in which the insulating layer 160 is laminated on the substrate 110 may be a single wiring substrate. More specifically, the insulating layer 160 may be formed of an insulative and flexible material such as PI, PET, or PEN, and may be integrated with the substrate 110 to form a single substrate.

The auxiliary electrode 170, which is an electrode that electrically connects the first electrode 120 and the semiconductor light emitting element 150, is positioned on the insulating layer 160, and is disposed to correspond to the position of the first electrode 120. For example, the auxiliary electrode 170 may have a dot shape and may be electrically connected to the first electrode 120 by an electrode hole 171 formed through the insulating layer 160. The electrode hole 171 may be formed by filling a via hole with a conductive material.

As shown in FIGS. 2 or 3A, a conductive adhesive layer 130 may be formed on one surface of the insulating layer 160, but embodiments of the present disclosure are not limited thereto. For example, a layer performing a specific function may be formed between the insulating layer 160 and the conductive adhesive layer 130, or the conductive adhesive layer 130 may be disposed on the substrate 110 without the insulating layer 160. In a structure in which the conductive adhesive layer 130 is disposed on the substrate 110, the conductive adhesive layer 130 may serve as an insulating layer.

The conductive adhesive layer 130 may be a layer having adhesiveness and conductivity. For this purpose, a material having conductivity and a material having adhesiveness may be mixed in the conductive adhesive layer 130. In addition, the conductive adhesive layer 130 may have ductility, thereby providing making the display device flexible.

As an example, the conductive adhesive layer 130 may be an anisotropic conductive film (ACF), an anisotropic conductive paste, a solution containing conductive particles, or the like. The conductive adhesive layer 130 may be configured as a layer that allows electrical interconnection in the direction of the Z-axis extending through the thickness, but is electrically insulative in the horizontal X-Y direction. Accordingly, the conductive adhesive layer 130 may be referred to as a Z-axis conductive layer (hereinafter, referred to simply as a "conductive adhesive layer").

The ACF is a film in which an anisotropic conductive medium is mixed with an insulating base member. When the ACF is subjected to heat and pressure, only a specific portion thereof becomes conductive by the anisotropic conductive medium. Hereinafter, it will be described that heat and pressure are applied to the ACF. However, another method may be used to make the ACF partially conductive. The other method may be, for example, application of only one of the heat and pressure or UV curing.

In addition, the anisotropic conductive medium may be, for example, conductive balls or conductive particles. For example, the ACF may be a film in which conductive balls are mixed with an insulating base member. Thus, when heat and pressure are applied to the ACF, only a specific portion of the ACF is allowed to be conductive by the conductive balls. The ACF may contain a plurality of particles formed by coating the core of a conductive material with an insulating film made of a polymer material. In this case, as the insulating film is destroyed in a portion to which heat and pressure are applied, the portion is made to be conductive by the core. At this time, the cores may be deformed to form layers that contact each other in the thickness direction of the film. As a more specific example, heat and pressure are applied to the whole ACF, and an electrical connection in the Z-axis direction is partially formed by the height difference of a counterpart adhered by the ACF.

As another example, the ACF may contain a plurality of particles formed by coating an insulating core with a conductive material. In this case, as the conductive material is deformed (pressed) in a portion to which heat and pressure are applied, the portion is made to be conductive in the thickness direction of the film. As another example, the conductive material may be disposed through the insulating base member in the Z-axis direction to provide conductivity in the thickness direction of the film. In this case, the conductive material may have a pointed end.

The ACF may be a fixed array ACF in which conductive balls are inserted into one surface of the insulating base member. More specifically, the insulating base member may be formed of an adhesive material, and the conductive balls may be intensively disposed on the bottom portion of the insulating base member. Thus, when the base member is subjected to heat and pressure, it may be deformed together with the conductive balls, exhibiting conductivity in the vertical direction.

However, the present disclosure is not necessarily limited thereto, and the ACF may be formed by randomly mixing conductive balls in the insulating base member, or may be composed of a plurality of layers with conductive balls arranged on one of the layers (as a double- ACF).

The anisotropic conductive paste may be a combination of a paste and conductive balls, and may be a paste in which conductive balls are mixed with an insulating and adhesive base material. Also, the solution containing conductive particles may be a solution containing any conductive particles or nanoparticles.

Referring back to FIG. 3A, the second electrode 140 is positioned on the insulating layer 160 and spaced apart from the auxiliary electrode 170. That is, the conductive adhesive layer 130 is disposed on the insulating layer 160 having the auxiliary electrode 170 and the second electrode 140 positioned thereon.

After the conductive adhesive layer 130 is formed with the auxiliary electrode 170 and the second electrode 140 positioned on the insulating layer 160, the semiconductor light emitting element 150 is connected thereto in a flip-chip form by applying heat and pressure. Thereby, the semiconductor light emitting element 150 is electrically connected to the first electrode 120 and the second electrode 140.

Referring to FIG. 4, the semiconductor light emitting element may be a flip chip-type light emitting device.

For example, the semiconductor light emitting element may include a p-type electrode 156, a p-type semiconductor layer 155 on which the p-type electrode 156 is formed, an active layer 154 formed on the p-type semiconductor layer 155, an n-type semiconductor layer 153 formed on the active layer 154, and an n-type electrode 152 disposed on the n-type semiconductor layer 153 and horizontally spaced apart from the p-type electrode 156. In this case, the p-type electrode 156 may be electrically connected to the auxiliary electrode 170, which is shown in FIG. 3, by the conductive adhesive layer 130, and the n-type electrode 152 may be electrically connected to the second electrode 140.

Referring back to FIGS. 2, 3A and 3B, the auxiliary electrode 170 may be elongated in one direction. Thus, one auxiliary electrode may be electrically connected to the plurality of semiconductor light emitting elements 150. For example, p-type electrodes of semiconductor light emitting elements on left and right sides of an auxiliary electrode may be electrically connected to one auxiliary electrode.

More specifically, the semiconductor light emitting element 150 may be press-fitted into the conductive adhesive layer 130 by heat and pressure. Thereby, only the portions of the semiconductor light emitting element 150 between the p-type electrode 156 and the auxiliary electrode 170 and between the n-type electrode 152 and the second electrode 140 may exhibit conductivity, and the other portions of the semiconductor light emitting element 150 do not exhibit conductivity as they are not press-fitted. In this way, the conductive adhesive layer 130 interconnects and electrically connects the semiconductor light emitting element 150 and the auxiliary electrode 170 and interconnects and electrically connects the semiconductor light emitting element 150 and the second electrode 140.

The plurality of semiconductor light emitting elements 150 may constitute a light emitting device array, and a phosphor conversion layer 180 may be formed on the light emitting device array.

The light emitting device array may include a plurality of semiconductor light emitting elements having different luminance values. Each semiconductor light emitting element 150 may constitute a unit pixel and may be electrically connected to the first electrode 120. For example, a plurality of first electrodes 120 may be provided, and the semiconductor light emitting elements may be arranged in, for example, several columns. The semiconductor light emitting elements in each column may be electrically connected to any one of the plurality of first electrodes.

In addition, since the semiconductor light emitting elements are connected in a flip-chip form, semiconductor light emitting elements grown on a transparent dielectric substrate may be used. The semiconductor light emitting elements may be, for example, nitride semiconductor light emitting elements. Since the semiconductor light emitting element 150 has excellent luminance, it may constitute an individual unit pixel even when it has a small size.

As shown in FIG. 3, a partition wall 190 may be formed between the semiconductor light emitting elements 150. In this case, the partition wall 190 may serve to separate individual unit pixels from each other, and may be integrated with the conductive adhesive layer 130. For example, by inserting the semiconductor light emitting element 150 into the ACF, the base member of the ACF may form the partition wall.

In addition, when the base member of the ACF is black, the partition wall 190 may have reflectance and increase contrast even without a separate black insulator.

As another example, a reflective partition wall may be separately provided as the partition wall 190. In this case, the partition wall 190 may include a black or white insulator depending on the purpose of the display device. When a partition wall including a white insulator is used, reflectivity may be increased. When a partition wall including a black insulator is used, it may have reflectance and increase contrast.

The phosphor conversion layer 180 may be positioned on the outer surface of the semiconductor light emitting element 150. For example, the semiconductor light emitting element 150 may be a blue semiconductor light emitting element that emits blue (B) light, and the phosphor conversion layer 180 may function to convert the blue (B) light into a color of a unit pixel. The phosphor conversion layer 180 may be a red phosphor 181 or a green phosphor 182 constituting an individual pixel.

That is, the red phosphor 181 capable of converting blue light into red (R) light may be laminated on a blue semiconductor light emitting element at a position of a unit pixel of red color, and the green phosphor 182 capable of converting blue light into green (G) light may be laminated on the blue semiconductor light emitting element at a position of a unit pixel of green color. Only the blue semiconductor light emitting element may be used alone in the portion constituting the unit pixel of blue color. In this case, unit pixels of red (R), green (G), and blue (B) may constitute one pixel. More specifically, a phosphor of one color may be laminated along each line of the first electrode 120. Accordingly, one line on the first electrode 120 may be an electrode for controlling one color. That is, red (R), green (G), and blue (B) may be sequentially disposed along the second electrode 140, thereby implementing a unit pixel.

However, embodiments of the present disclosure are not limited thereto. Unit pixels of red (R), green (G), and blue (B) may be implemented by combining the semiconductor light emitting element 150 and the quantum dot (QD) rather than using the phosphor.

Also, a black matrix 191 may be disposed between the phosphor conversion layers to improve contrast. That is, the black matrix 191 may improve contrast of light and darkness.

However, embodiments of the present disclosure are not limited thereto, and anther structure may be applied to implement blue, red, and green colors.

Referring to FIG. 5A, each semiconductor light emitting element may be implemented as a high-power light emitting device emitting light of various colors including blue by using gallium nitride (GaN) as a main material and adding indium (In) and/or aluminum (Al).

In this case, each semiconductor light emitting element may be a red, green, or blue semiconductor light emitting element to form a unit pixel (sub-pixel). For example, red, green, and blue semiconductor light emitting elements R, G, and B may be alternately disposed, and unit pixels of red, green, and blue may constitute one pixel by the red, green and blue semiconductor light emitting elements. Thereby, a full-color display may be implemented.

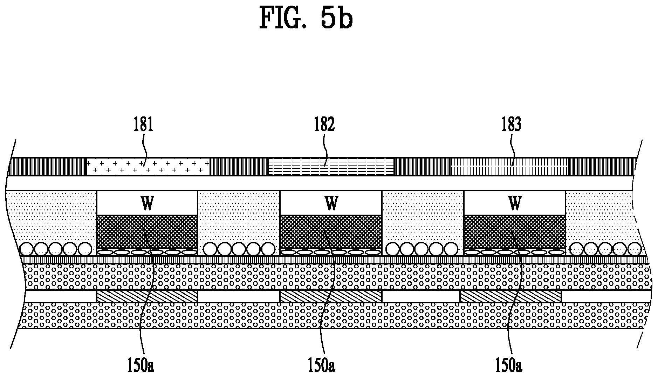

Referring to FIG. 5B, the semiconductor light emitting element 150a may include a white light emitting device W having a yellow phosphor conversion layer, which is provided for each device. In this case, in order to form a unit pixel, a red phosphor conversion layer 181, a green phosphor conversion layer 182, and a blue phosphor conversion layer 183 may be disposed on the white light emitting device W. In addition, a unit pixel may be formed using a color filter repeating red, green, and blue on the white light emitting device W.

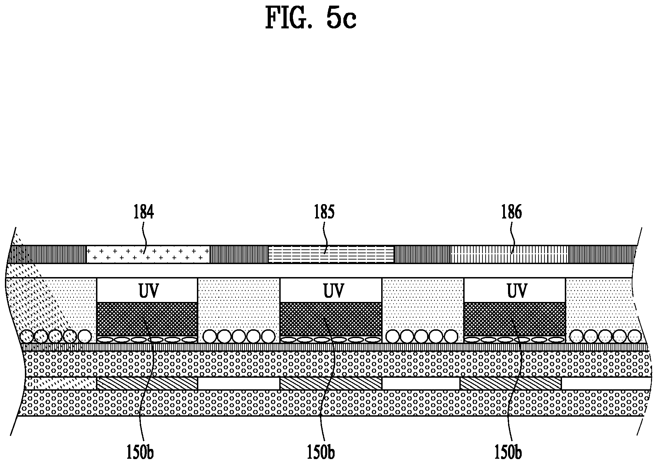

Referring to FIG. 5C, a red phosphor conversion layer 181, a green phosphor conversion layer 185, and a blue phosphor conversion layer 183 may be provided on a ultraviolet light emitting device. Not only visible light but also ultraviolet (UV) light may be used in the entire region of the semiconductor light emitting element. In an embodiment, UV may be used as an excitation source of the upper phosphor in the semiconductor light emitting element.

Referring back to this example, the semiconductor light emitting element is positioned on the conductive adhesive layer to constitute a unit pixel in the display device. Since the semiconductor light emitting element has excellent luminance, individual unit pixels may be configured despite even when the semiconductor light emitting element has a small size.

Regarding the size of such an individual semiconductor light emitting element, the length of each side of the device may be, for example, 80 µm or less, and the device may have a rectangular or square shape. When the semiconductor light emitting element has a rectangular shape, the size thereof may be less than or equal to 20 µm × 80 µm.

In addition, even when a square semiconductor light emitting element having a side length of 10 µm is used as a unit pixel, sufficient brightness to form a display device may be obtained.

Therefore, for example, in case of a rectangular pixel having a unit pixel size of 600 *µ*m × 300 *µ*m (i.e., one side by the other side), a distance of a semiconductor light emitting element becomes sufficiently long relatively.

Thus, in this case, it is able to implement a flexible display device having high image quality over HD image quality.

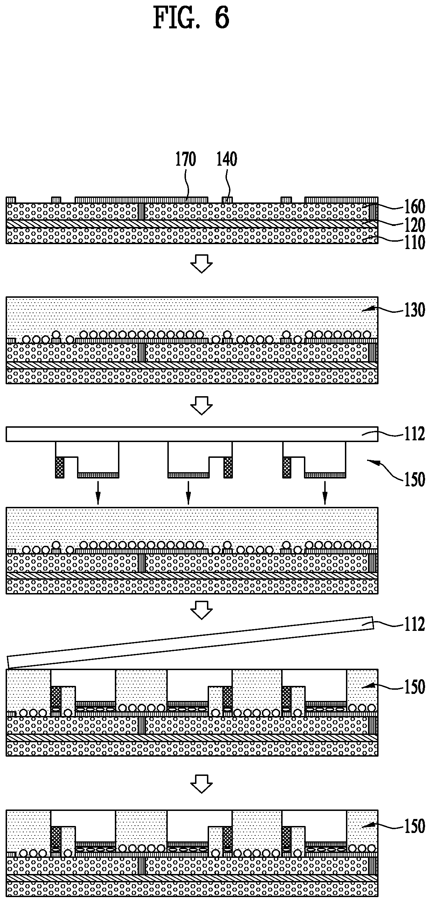

The above-described display device using the semiconductor light emitting element may be prepared by a new fabricating method. Such a fabricating method will be described with reference to FIG. 6 as follows.

FIG. 6 shows cross-sectional views of a method of fabricating a display device using a semiconductor light emitting element according to the present disclosure.

Referring to FIG. 6, first of all, a conductive adhesive layer 130 is formed on an insulating layer 160 located between an auxiliary electrode 170 and a second electrode 140. The insulating layer 160 is tacked on a wiring substrate 110. On the wiring substrate 110, a first electrode 120, the auxiliary electrode 170 and the second electrode 140 are disposed. In this case, the first electrode 120 and the second electrode 140 may be disposed in mutually orthogonal directions, respectively. In order to implement a flexible display device, the wiring substrate 110 and the insulating layer 160 may include glass or polyimide (PI) each.

For example, the conductive adhesive layer 130 may be implemented by an anisotropic conductive film. To this end, an anisotropic conductive film may be coated on the substrate on which the insulating layer 160 is located.

Subsequently, a temporary substrate 112, on which a plurality of semiconductor light emitting elements 150 configuring individual pixels are located to correspond to locations of the auxiliary electrode 170 and the second electrodes 140, is disposed in a manner that the semiconductor light emitting element 150 confronts the auxiliary electrode 170 and the second electrode 140.

In this regard, the temporary 112 substrate 112 is a growing substrate for growing the semiconductor light emitting element 150 and may include a sapphire or silicon substrate.

The semiconductor light emitting element is configured to have a space and size for configuring a display device when formed in unit of wafer, thereby being effectively used for the display device.

Subsequently, the wiring substrate 110 and the temporary substrate 112 are thermally compressed together. By the thermocompression, the wiring substrate 110 and the temporary substrate 112 are bonded together. Owing to the property of an anisotropic conductive film having conductivity by thermocompression, only a portion among the semiconductor light emitting element 150, the auxiliary electrode 170 and the second electrode 140 has conductivity, via which the electrodes and the semiconductor light emitting element 150 may be connected electrically. In this case, the semiconductor light emitting element 150 is inserted into the anisotropic conductive film, by which a partition wall may be formed between the semiconductor light emitting elements 150.

Then the temporary substrate 112 is removed. For example, the temporary substrate 112 may be removed using Laser Lift-Off (LLO) or Chemical Lift-Off (CLO).

Finally, by removing the temporary substrate 112, the semiconductor light emitting elements 150 exposed externally. If necessary, the wiring substrate 110 to which the semiconductor light emitting elements 150 are coupled may be coated with silicon oxide (SiOx) or the like to form a transparent insulating layer (not shown).

In addition, a step of forming a phosphor layer on one side of the semiconductor light emitting element 150 may be further included. For example, the semiconductor light emitting element 150 may include a blue semiconductor light emitting element emitting Blue (B) light, and a red or green phosphor for converting the blue (B) light into a color of a unit pixel may form a layer on one side of the blue semiconductor light emitting element.

The above-described fabricating method or structure of the display device using the semiconductor light emitting element may be modified into various forms. For example, the above-described display device may employ a vertical semiconductor light emitting element.

Furthermore, a modification or embodiment described in the following may use the same or similar reference numbers for the same or similar configurations of the former example and the former description may apply thereto.

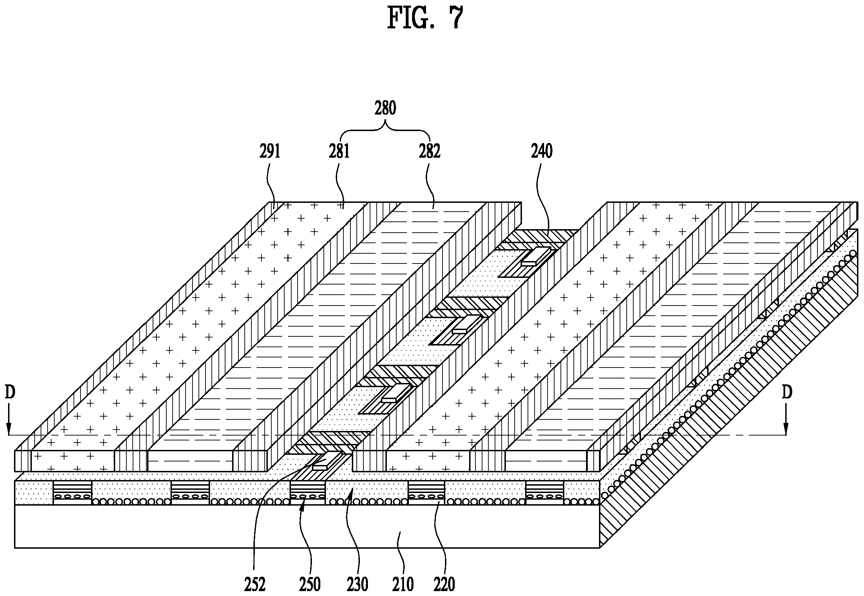

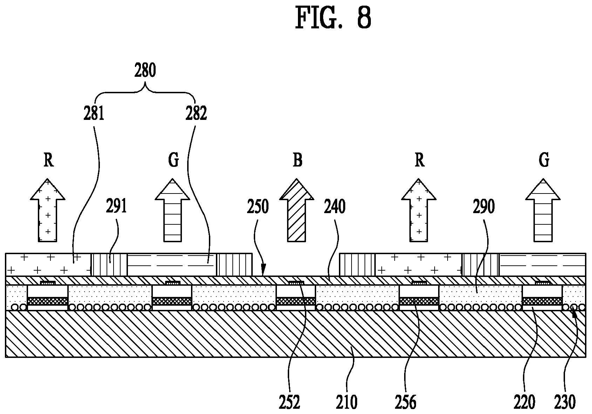

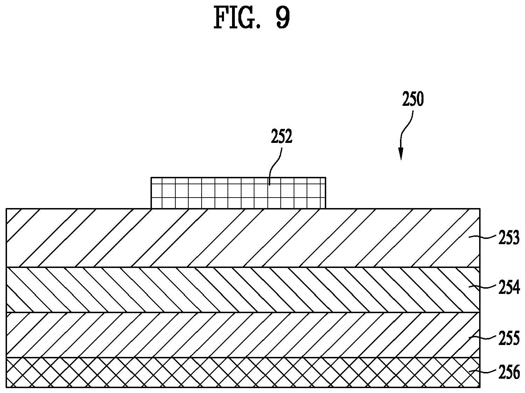

FIG. 7 is a perspective diagram of a display device using a semiconductor light emitting element according to another embodiment of the present disclosure, FIG. 8 is a cross-sectional diagram taken along a cutting line D-D shown in FIG. 8, and FIG. 9 is a conceptual diagram showing a vertical type semiconductor light emitting element shown in FIG. 8.

Referring to the present drawings, a display device may employ a vertical semiconductor light emitting device of a Passive Matrix (PM) type.

The display device includes a substrate 210, a first electrode 220, a conductive adhesive layer 230, a second electrode 240 and at least one semiconductor light emitting element 250.

The substrate 210 is a wiring substrate on which the first electrode 220 is disposed and may contain polyimide (PI) to implement a flexible display device. Besides, the substrate 210 may use any substance that is insulating and flexible.

The first electrode 210 is located on the substrate 210 and may be formed as a bar type electrode that is long in one direction. The first electrode 220 may be configured to play a role as a data electrode.

The conductive adhesive layer 230 is formed on the substrate 210 where the first electrode 220 is located. Like a display device to which a light emitting device of a flip chip type is applied, the conductive adhesive layer 230 may include one of an Anisotropic Conductive Film (ACF), an anisotropic conductive paste, a conductive particle contained solution and the like. Yet, in the present embodiment, a case of implementing the conductive adhesive layer 230 with the anisotropic conductive film is exemplified.

After the conductive adhesive layer has been placed in the state that the first electrode 220 is located on the substrate 210, if the semiconductor light emitting element 250 is connected by applying heat and pressure thereto, the semiconductor light emitting element 250 is electrically connected to the first electrode 220. In doing so, the semiconductor light emitting element 250 is preferably disposed to be located on the first electrode 220.

If heat and pressure is applied to an anisotropic conductive film, as described above, since the anisotropic conductive film has conductivity partially in a thickness direction, the electrical connection is established. Therefore, the anisotropic conductive film is partition walled into a conductive portion and a non-conductive portion.

Furthermore, since the anisotropic conductive film contains an adhesive component, the conductive adhesive layer 230 implements mechanical coupling between the semiconductor light emitting element 250 and the first electrode 220 as well as mechanical connection.

Thus, the semiconductor light emitting element 250 is located on the conductive adhesive layer 230, via which an individual pixel is configured in the display device. As the semiconductor light emitting element 250 has excellent luminance, an individual unit pixel may be configured in small size as well. Regarding a size of the individual semiconductor light emitting element 250, a length of one side may be equal to or smaller than 80 *µ*m for example and the individual semiconductor light emitting element 250 may include a rectangular or square element. For example, the rectangular element may have a size equal to or smaller than 20 *µ*m × 80 *µ*m.

The semiconductor light emitting element 250 may have a vertical structure.

Among the vertical type semiconductor light emitting elements, a plurality of second electrodes 240 respectively and electrically connected to the vertical type semiconductor light emitting elements 250 are located in a manner of being disposed in a direction crossing with a length direction of the first electrode 220.

Referring to FIG. 9, the vertical type semiconductor light emitting element 250 includes a p-type electrode 256, a p-type semiconductor layer 255 formed on the p-type electrode 256, an active layer 254 formed on the p-type semiconductor layer 255, an n-type semiconductor layer 253 formed on the active layer 254, and an n-type electrode 252 formed on then-type semiconductor layer 253. In this case, the p-type electrode 256 located on a bottom side may be electrically connected to the first electrode 220 by the conductive adhesive layer 230, and the n-type electrode 252 located on a top side may be electrically connected to a second electrode 240 described later. Since such a vertical type semiconductor light emitting element 250 can dispose the electrodes at top and bottom, it is considerably advantageous in reducing a chip size.

Referring to FIG. 8 again, a phosphor layer 280 may formed on one side of the semiconductor light emitting element 250. For example, the semiconductor light emitting element 250 may include a blue semiconductor light emitting element 251 emitting blue (B) light, and a phosphor layer 280 for converting the blue (B) light into a color of a unit pixel may be provided. In this regard, the phosphor layer 280 may include a red phosphor 281 and a green phosphor 282 configuring an individual pixel.

Namely, at a location of configuring a red unit pixel, the red phosphor 281 capable of converting blue light into red (R) light may be stacked on a blue semiconductor light emitting element. At a location of configuring a green unit pixel, the green phosphor 282 capable of converting blue light into green (G) light may be stacked on the blue semiconductor light emitting element. Moreover, the blue semiconductor light emitting element may be singly usable for a portion that configures a blue unit pixel. In this case, the unit pixels of red (R), green (G) and blue (B) may configure a single pixel.

Yet, the present disclosure is non-limited by the above description. In a display device to which a light emitting element of a flip chip type is applied, as described above, a different structure for implementing blue, red and green may be applicable.

Regarding the present embodiment again, the second electrode 240 is located between the semiconductor light emitting elements 250 and connected to the semiconductor light emitting elements electrically. For example, the semiconductor light emitting elements 250 are disposed in a plurality of columns, and the second electrode 240 may be located between the columns of the semiconductor light emitting elements 250.

Since a distance between the semiconductor light emitting elements 250 configuring the individual pixel is sufficiently long, the second electrode 240 may be located between the semiconductor light emitting elements 250.

The second electrode 240 may be formed as an electrode of a bar type that is long in one direction and disposed in a direction vertical to the first electrode.

In addition, the second electrode 240 and the semiconductor light emitting element 250 may be electrically connected to each other by a connecting electrode protruding from the second electrode 240. Particularly, the connecting electrode may include a n-type electrode of the semiconductor light emitting element 250. For example, the n-type electrode is formed as an ohmic electrode for ohmic contact, and the second electrode covers at least one portion of the ohmic electrode by printing or deposition. Thus, the second electrode 240 and the n-type electrode of the semiconductor light emitting element 250 may be electrically connected to each other.

Referring to FIG. 8 again, the second electrode 240 may be located on the conductive adhesive layer 230. In some cases, a transparent insulating layer (not shown) containing silicon oxide (SiOx) and the like may be formed on the substrate 210 having the semiconductor light emitting element 250 formed thereon. If the second electrode 240 is placed after the transparent insulating layer has been formed, the second electrode 240 is located on the transparent insulating layer. Alternatively, the second electrode 240 may be formed in a manner of being spaced apart from the conductive adhesive layer 230 or the transparent insulating layer.

If a transparent electrode of Indium Tin Oxide (ITO) or the like is sued to place the second electrode 240 on the semiconductor light emitting element 250, there is a problem that ITO substance has poor adhesiveness to an n-type semiconductor layer. Therefore, according to the present disclosure, as the second electrode 240 is placed between the semiconductor light emitting elements 250, it is advantageous in that a transparent electrode of ITO is not used. Thus, light extraction efficiency can be improved using a conductive substance having good adhesiveness to an n-type semiconductor layer as a horizontal electrode without restriction on transparent substance selection.

Referring to FIG. 8 again, a partition wall 290 may be located between the semiconductor light emitting elements 250. Namely, in order to isolate the semiconductor light emitting element 250 configuring the individual pixel, the partition wall 290 may be disposed between the vertical type semiconductor light emitting elements 250. In this case, the partition wall 290 may play a role in separating the individual unit pixels from each other and be formed with the conductive adhesive layer 230 as an integral part. For example, by inserting the semiconductor light emitting element 250 in an anisotropic conductive film, a base member of the anisotropic conductive film may form the partition wall.

In addition, if the base member of the anisotropic conductive film is black, the partition wall 290 may have reflective property as well as a contrast ratio may be increased, without a separate block insulator.

For another example, a reflective partition wall may be separately provided as the partition wall 190. The partition wall 290 may include a black or white insulator depending on the purpose of the display device.

In case that the second electrode 240 is located right onto the conductive adhesive layer 230 between the semiconductor light emitting elements 250, the partition wall 290 may be located between the vertical type semiconductor light emitting element 250 and the second electrode 240 each. Therefore, an individual unit pixel may be configured using the semiconductor light emitting element 250. Since a distance between the semiconductor light emitting elements 250 is sufficiently long, the second electrode 240 can be placed between the semiconductor light emitting elements 250. And, it may bring an effect of implementing a flexible display device having HD image quality.

In addition, as shown in FIG. 8, a black matrix 291 may be disposed between the respective phosphors for the contrast ratio improvement. Namely, the black matrix 291 may improve the contrast between light and shade.

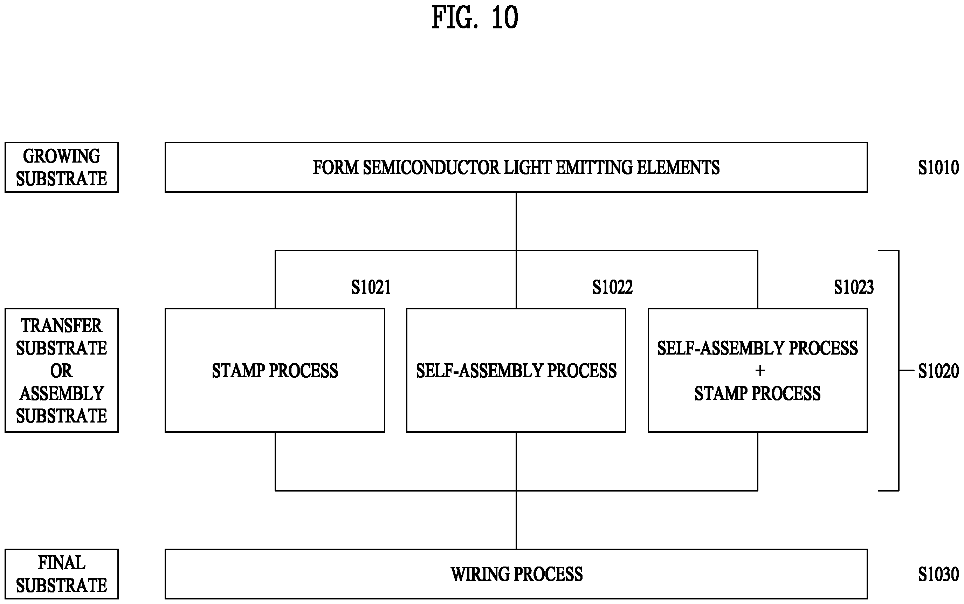

FIG. 10 is a flowchart schematically representing a method for manufacturing a display device using semiconductor light emitting elements.

First, the semiconductor light emitting elements are formed on growth substrates (S1010). The semiconductor light emitting elements may include a first conductivity-type semiconductor layer, an active layer and a second conductivity-type semiconductor layer. The semiconductor light emitting elements may further include a first conductivity-type electrode formed on the first conductivity-type semiconductor layer and a second conductivity-type electrode formed on the second conductivity-type semiconductor layer.

The semiconductor light emitting elements may be horizontal semiconductor light emitting elements or vertical semiconductor light emitting elements. When the semiconductor light emitting elements are vertical semiconductor light emitting elements, the first conductivity-type electrode and the second conductivity-type electrode face each other, and thus, a process of separating the semiconductor light emitting elements from the growth substrate and then forming any one of the first and second conductivity-type electrodes in one direction is added. Further, as will be described later, the semiconductor light emitting elements may include a magnetic layer so as to perform the self-assembly process.

In order to apply the semiconductor light emitting elements to a display device, in general, three kinds of semiconductor light emitting elements configured to emit light of red (R), green (G) and blue (B) are necessary. Since semiconductor light emitting elements configured to emit light of one color are formed on one growth substrate, a separate substrate is required to manufacture the display device which implements respective unit pixels using the above three kinds of semiconductor light emitting elements. Therefore, the respective semiconductor light emitting elements need to be separated from the growth substrates and then be assembled on or transferred to a final substrate. The final substrate is a substrate on which a process of forming wiring electrodes applying voltage to the semiconductor light emitting elements so as to enable the semiconductor light emitting elements to emit light is performed.

Therefore, the semiconductor light emitting elements configured to emit light of respective colors may be primarily moved to a transfer substrate or an assembly substrate (S1020), and may be finally transferred to the final substrate. In some cases, when a metallization process is performed on the transfer substrate or the assembly substrate, the transfer substrate or the assembly substrate may serve as the final substrate.

The semiconductor light emitting elements may be arranged on the transfer substrate or the assembly substrate by the following three methods (S1020).

First, the semiconductor light emitting elements may be transferred from the growth substrate to the transfer substrate by a stamping process (S1021). The stamping process indicates a process in which semiconductor light emitting elements are separated from a growth substrate using a substrate which is formed of a flexible material and has adhesive protrusions, through the protrusions. The semiconductor light emitting elements may be selectively separated from the growth substrate by controlling the distance between the protrusions and the arrangement of the protrusions.

Second, the semiconductor light emitting elements may be assembled with the assembly substrate using the self-assembly process, as described above (S1022). In order to perform the self-assembly process, the semiconductor light emitting elements should be separated from the growth substrate so as to be prepared individually, and thus, a number of the semiconductor light emitting elements corresponding to the number needed is separated from the growth substrates through a Laser Lift Off (LLO) process. Thereafter, the semiconductor light emitting elements are dispersed in fluid, and are assembled on the assembly substrate using an electromagnetic field.

In the self-assembly process, the respective semiconductor light emitting elements configured to implement light of R, G and B may be simultaneously assembled on one assembly substrate, or the semiconductor light emitting elements configured to implement light of the respective colors may be assembled through respective assembly substrates.

Third, both the stamping process and the self-assembly process may be used (S1023). First, the semiconductor light emitting elements are located on the assembly substrate through the self-assembly process, and then, the semiconductor light emitting elements are transferred to the final substrate through the stamping process. Since it is difficult to implement a large-area assembly substrate due to the position of the assembly substrate disposed during the self-assembly process, contact with the fluid, the effect of the electromagnetic field, etc., the semiconductor light emitting elements may be assembled on the assembly substrate having an appropriate area and then the semiconductor light emitting elements on the assembly substrate are transferred to the final substrate having a large area plural times through the stamping process.

When the plurality of semiconductor light emitting elements configured to form respective unit pixels is arranged on the final substrate, the metallization process in which the semiconductor light emitting elements are conductively interconnected is performed (S1030).

Wiring electrodes formed through the metallization process conductively connect the semiconductor light emitting elements, assembled on or transferred to the substrate, to the substrate. Further, transistors configured to drive an active matrix may be formed in advance on the lower surface of the substrate. Therefore, the wiring electrodes may be conductively connected to the transistors.

In order to implement a large-scale display device, a large number of semiconductor light emitting elements is required, and thus, the self-assembly process is desirable. Further, in order to improve assembly speed, simultaneous assembly of the semiconductor light emitting elements configured to emit light of respective colors on one assembly substrate may be preferred during the self-assembly process. Further, in order to assemble the semiconductor light emitting elements configured to emit light of the respective colors with predetermined positions of the assembly substrate, the semiconductor light emitting elements may require mutually exclusive structures.

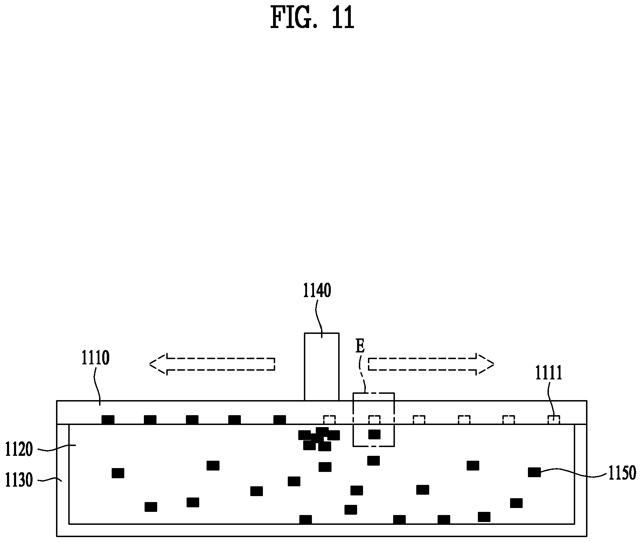

FIG. 11 is a diagram illustrating one embodiment of a method for assembling semiconductor light emitting elements on a substrate through the self-assembly process.

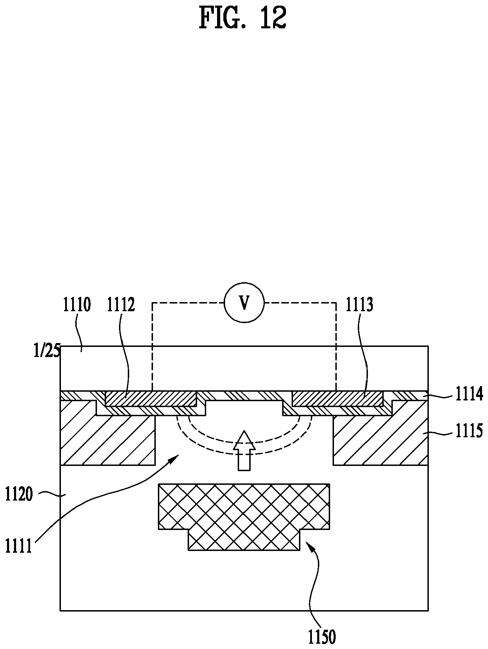

Further, FIG. 12 is an enlarged diagram illustrating a part E shown in FIG. 11.

Referring to FIGS. 11 and 12, semiconductor light emitting elements 1150 may be put into a chamber 1030 filled with a fluid 1020.

Thereafter, an assembly substrate 1110 may be placed on the chamber 1030. Depending on embodiments, the assembly substrate 1110 may be put into the chamber 1030. Here, the assembly substrate 1110 is put into the chamber 1030 in a direction in which assembly recesses 1111 of the assembly substrate 1110 face the fluid 1020.

A pair of electrodes 1112 and 1113 corresponding to each of the semiconductor light emitting elements 1150 to be assembled may be formed on the assembly substrate 1110. The electrodes 1112 and 1113 may be implemented as transparent electrodes (formed of ITO), or may be implemented using other general materials. The electrodes 1112 and 1113 may generate an electric field by voltage applied thereto, and may thus correspond to assembly electrodes which stably fix the semiconductor light emitting element 1050 coming into contact with the assembly electrodes 1112 and 1113.

Specifically, AC voltage may be applied to the electrodes 1112 and 1113, and the semiconductor light emitting element 1150 floating around the electrodes 1112 and 1113 may have polarity due to dielectric polarization. Further, the dielectrically polarized semiconductor light emitting element 1150 may be moved or fixed in a specific direction by a non-uniform electric field formed around the electrodes 1112 and 1113. This may be referred to as dielectrophoresis (DEP) and, during the self-assembly process according to the present disclosure, the semiconductor light emitting elements 1150 may be stably fixed to the assembly recesses 1111 using dielectrophoresis. The magnitude of dielectrophoresis (i.e., DEP force) is proportional to the intensity of an electric field, and is varied depending on the degree of dielectric polarization in the semiconductor light emitting element.

Further, the distance between the assembly electrodes 1112 and 1113 may be less than, for example, the width of the semiconductor light emitting elements 1150 and the diameter of the assembly recesses 1111, and the assembled positions of the semiconductor light emitting elements 1150 using an electric field may be more precisely fixed.

Further, an insulating layer 1114 may be formed on the assembly electrodes 1112 and 1113, and may thus protect the electrodes 1112 and 1113 from the fluid 1020 and prevent leakage of current flowing in the assembly electrodes 1112 and 1113. For example, the insulating layer 1114 may be formed as a single layer or multilayer structure using inorganic insulators, such as silica, alumina, etc., or organic insulators. In addition, the insulating layer 1114 may have a minimum thickness so as to prevent damage to the assembly electrodes 1112 and 1113 when the semiconductor light emitting elements 1150 are assembled with the assembly electrodes 1112 and 1113, and may have a maximum thickness so as to stably assemble the semiconductor light emitting elements 1150.

A partition wall 1115 may be formed on the insulting layer 1114. Some regions of the partition wall 1115 may be located on the assembly electrodes 1112 and 1113, and remaining regions may be located on the assembly substrate 1110.

For example, when the assembly substrate 1110 is manufactured, the assembly recesses 1111 through which the respective semiconductor light emitting elements 1150 are coupled to the assembly substrate 1110 may be formed by removing some parts of the partition wall 1115 formed on the entirety of the insulating layer 1114.

As shown in FIG. 12, the assembly recesses 1111 to which the semiconductor light emitting elements 1150 are coupled may be formed on the assembly substrate 1110, and the surface of the assembly substrate 1110 on which the assembly recesses 1111 are formed may come into contact with the fluid 1120. The assembly recesses 1111 may accurately guide the semiconductor light emitting elements 1150 to the assembly positions thereof.

Further, the partition wall 1115 may be formed to have a designated inclination in a direction from the opening of the assembly recess 1111 to the bottom surface of the assembly recess 1111. For example, through control of the inclination of the partition wall 1115, the assembly recess 1111 may have the opening and the bottom surface, and the area of the opening may be greater than the area of the bottom surface. Thereby, the semiconductor light emitting element 1150 may be assembled with the accurate position of the bottom surface in the assembly recess 1111.

Each of the assembly recesses 1111 may have a shape and a size corresponding to the shape of a corresponding one of the semiconductor light emitting elements 1150 assembled therewith. Accordingly, assembly of other semiconductor light emitting elements with the assembly recesses 1111 or assembly of a plurality of semiconductor light emitting elements with one of the assembly recesses 1111 may be prevented.

Further, the depth of the assembly recesses 1111 may be less than the vertical height of the semiconductor light emitting elements 1150. Therefore, the semiconductor light emitting elements 1150 may protrude from the partition wall 1115, and may easily come into contact with protrusions of a transfer substrate during a transfer process after assembly.

Further, after the assembly substrate 1110 is disposed, as shown in FIG. 12, an assembly apparatus 1140 including a magnetic body may be moved along the assembly substrate 1110. The assembly apparatus 1140 may be moved in the state in which the assembly apparatus 1140 comes into contact with the assembly substrate 1110, so as to maximize a region, which a magnetic field affects, up to the inside of the fluid 1120. For example, the assembly apparatus 1140 may include a plurality of magnetic bodies, or may include a magnetic body having a size corresponding to the size of the assembly substrate 1110. In this case, the moving distance of the assembly apparatus 1140 may be restricted to within a designated range.

By the magnetic field generated by the assembly apparatus 1140, the semiconductor light emitting elements 1150 in the chamber 1110 may be moved towards the assembly apparatus 1140.

While the semiconductor light emitting elements 1150 are moved towards the assembly apparatus 1140, the semiconductor light emitting elements 1150 may enter the assembly recesses 1111, and may thus come into contact with the assembly substrate 1110, as shown in FIG. 12.

Further, the semiconductor light emitting elements 1150 may include a magnetic layer formed therein so as to perform the self-assembly process.

Due to the electric field generated by the assembly electrodes 1112 and 1113 of the assembly substrate 1110, release of the semiconductor light emitting elements 1150 coming into contact with the assembly substrate 1110 from the assembly substrate 1110 by movement of the assembly apparatus 1140 may be prevented.

Therefore, by the self-assembly method using an electromagnetic field, as shown in FIGS. 11 and 12, the plurality of semiconductor light emitting elements 1150 may be simultaneously assembled on the assembly substrate 1110.

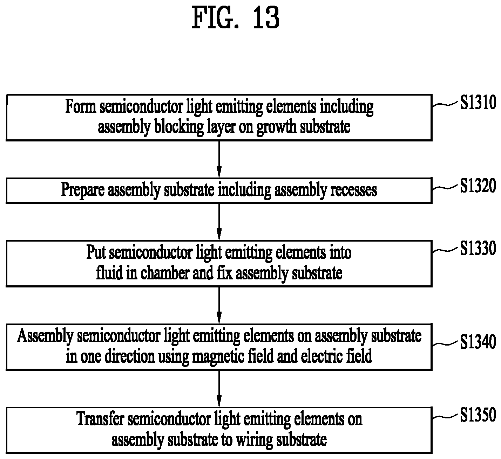

FIG. 13 is a flowchart schematically representing a method for manufacturing a display device using semiconductor light emitting elements according to the present disclosure.

First, semiconductor light emitting elements including an assembly blocking (or obstructing) layer are formed on respective growth substrates (S1310). As will be described later, the assembly blocking layer may indicate a first etching layer having an uneven structure by electrochemical etching.

Thereafter, an assembly substrate including assembly recesses is prepared (S1320). The assembly substrate further includes assembly electrodes configured to generate an electric field.

Subsequently, the semiconductor light emitting elements are put into a chamber filled with fluid, and the assembly substrate is fixed to the upper part of the chamber (S1330).

Thereafter, the semiconductor light emitting elements are attracted in a direction towards the assembly substrate using a magnetic field generated by an assembly apparatus including a magnetic body by placing the assembly apparatus on the rear surface of the assembly substrate, and are assembled with the assembly recesses of the assembly substrate in one direction using an electric field generated by applying voltage to the assembly electrodes (S1340). Since DEP force has little influence in a direction in which the assembly blocking layer is located on each of the semiconductor light emitting elements and thus it is difficult to stably fix the semiconductor light emitting element to the assembly recess using one surface of the semiconductor light emitting element provided with the assembly blocking layer formed thereon, an assembly surface of the semiconductor light emitting element assembled on the assembly substrate may be the other surface of the semiconductor light emitting element opposite to the surface of the semiconductor light emitting element provided with the assembly blocking layer formed thereon.

Finally, the semiconductor light emitting elements assembled on the assembly substrate are transferred to a wiring substrate (S1350). After transfer of the semiconductor light emitting elements to the wiring substrate, the metallization process in which the semiconductor light emitting elements are conductively connected to the wiring substrate is additionally performed.

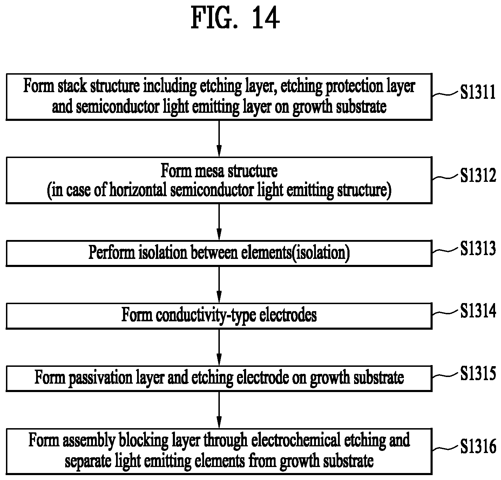

FIG. 14 is a flowchart schematically representing a method for manufacturing the semiconductor light emitting elements according to the present disclosure on the growth substrate.

First, a stack structure including an etching layer, an etching protection layer and a semiconductor light emitting layer is formed on the growth substrate (S1311). A buffer layer may be additionally formed between the growth substrate and the etching layer. The semiconductor light emitting layer is a basic structure configured to emit light, and may include a first conductivity-type semiconductor layer, an active layer and a second conductivity-type semiconductor layer. Further, when one of the first conductivity-type semiconductor layer and the second conductivity-type semiconductor layer is an N-type semiconductor layer, the other may be a P-type semiconductor layer, and thus ,the semiconductor light emitting layer may form a P-N diode structure.

After formation of the stack structure (S1311), a mesa structure may be formed by performing etching so that some regions of the conductivity-type semiconductor layer disposed in the lower portion of the stack structure are exposed (S1312). In this case, some regions of both the first conductivity-type semiconductor layer and the second conductivity-type semiconductor layer may be exposed in one direction. Therefore, a first conductivity-type electrode may be formed in the exposed regions of the first conductivity-type semiconductor layer, a second conductivity-type electrode may be formed in the exposed regions of the second conductivity-type semiconductor layer, and thus, the conductivity-type electrodes may form a horizontal semiconductor light emitting structure facing one direction. Therefore, in case of a vertical semiconductor light emitting element structure, formation of the mesa structure (S1312) is not necessarily required during the manufacturing process of the elements, and thus, formation of the mesa structure (S1312) can be omitted.

Thereafter, in order to define respective semiconductor light emitting elements, an isolation process is performed so as to expose some regions of the etching layer of the stack structure (S1313). The reason why some regions of the etching layer are exposed is to intentionally etch only the exposed regions of the etching layer during a subsequent etching process.

Thereafter, the first conductivity-type electrodes conductively connected to the first conductivity-type semiconductor layers of the isolated semiconductor light emitting elements and the second conductivity-type electrodes conductively connected to the second conductivity-type semiconductor layers of the isolated semiconductor light emitting elements are formed (S1314).

Subsequently, a passivation layer is formed so as to surround the outer surfaces of the semiconductor light emitting elements, and an etching electrode is formed on a part of the exposed regions of the etching layer on the growth substrate (S 1315).

Finally, the semiconductor light emitting elements are separated from the growth substrate through electrochemical etching, and the assembly blocking layer is formed on the separated surfaces of the semiconductor light emitting elements (S1316). The assembly blocking layer may include the etching layer remaining on the etching protection layer. The assembly blocking layer may serve to induce the semiconductor light emitting element to be assembled with the assembly recess in one direction in the fluid, and may control the direction of assembly of the semiconductor light emitting element depending on surface roughness of the etching layer remaining on the etching protection layer. Further, the assembly blocking layer may include the remaining etching layer and the etching protection layer. In this case, both the etching layer and the etching protection layer may be etched through the etching process, and may thus form a continuous etching pattern. Further, the etching pattern may have an uneven structure including protrusions.

It will be apparent to those skilled in the art that omission of or changes in some operations in the flowchart shown in FIG. 14 are included in the scope of the present disclosure, with respect to the overall gist of the present disclosure.

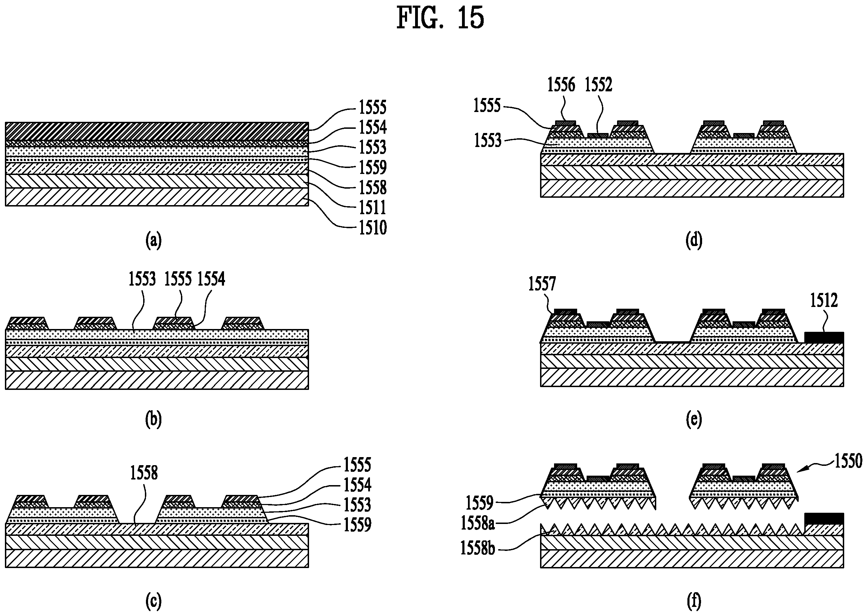

FIG. 15 shows cross-sectional diagrams illustrating the method for manufacturing the semiconductor light emitting elements according to the present disclosure on the growth substrate.

The semiconductor light emitting element according to the present disclosure is characterized in that it includes the assembly blocking layer, and the assembly blocking layer may include the etching layer and the etching protection layer.

As show in FIG. 15(a), a buffer layer 1511, an etching layer 1558, an etching protection layer 1559, a first conductivity-type semiconductor layer 1553, an active layer 1554, and a second conductivity-type semiconductor layer 1555 are sequentially stacked on a growth substrate 1510.

The thickness of the etching layer 1558 may be greater than an effective distance of DEP force, in consideration of the effective distance. For example, in case that the effective distance is 200 nm, the thickness of the etching layer 1558 may be equal to or greater than 200 nm. Therefore, the etching layer remaining after the etching process may be controlled so as to have a surface roughness value which is equal to or greater than the effective distance.

Further, the concentration of impurities in the etching layer 1558 may be greater than the concentration of impurities in the etching protection layer 1559. Since, in general, an etch rate increases as the concentration of impurities increases, and thus, there may be a difference in the concentrations of impurities between the etching layer 1558 and the etching protection layer 1559 so that etching may be concentrated upon the etching layer 1558. Further, the etching layer 1558 and the etching protection layer 1559 may be layers of the same semiconductor type. Further, the first conductivity-type semiconductor layer 1553 formed on the etching protection layer 1559 may be a layer of the same semiconductor type. For example, all of the etching layer 1558, the etching protection layer 1559 and the first conductivity-type semiconductor layer 1553 may be N-type semiconductor layers, and in this case, the concentration of impurities in the etching protection layer 1559 may be the minimum, the concentration of impurities in the first conductivity-type semiconductor layer 1553 may have an intermediate value, and the concentration of impurities in the etching layer 1558 may be the maximum. Further, the etching protection layer 1559 may be an undoped semiconductor layer in which a separate impurity doping process is not performed.

The etching layer 1558 may be formed as a uniform semiconductor layer having a designated lattice constant, and for this purpose, the buffer layer 1511 may be interposed between the growth substrate 1510 and the etching layer 1558.

Thereafter, as shown in FIG. 15(b), the second conductivity-type semiconductor layer 1555 and the active layer 1554 are etched in a mesa structure so as to expose the first conductivity-type semiconductor layer 1553. As described above, in case of a horizontal semiconductor light emitting element structure, the first conductivity-type semiconductor layer 1553 and the second conductivity-type semiconductor layer 1555 should be exposed in one direction and thus a mesa structure is formed, but, in case of a vertical semiconductor light emitting element structure, the mesa structure is not necessarily required. Therefore, the process shown in FIG. 15(b) corresponds to a selective process performed to prepare horizontal semiconductor light emitting elements.

Thereafter, as shown in FIG. 15(c), the first conductivity-type semiconductor layer 1553 and the etching protection layer 1559 may be additionally etched so as to expose the surface of the etching layer 1559. The exposed etching layer 1559 may be etched using a chemical solution during the etching process, and thereby, the semiconductor light emitting elements may be separated from the growth substrate 1510.

Further, an embodiment shown in FIG. 15 describes the structure of a horizontal semiconductor light emitting element, and more particularly, a structure in which the second conductivity-type semiconductor layer 1555 surrounds the upper edge of the semiconductor light emitting element. Therefore, two mesa structures in which the second conductivity-type semiconductor layer 1555 protrudes from two regions, may be observed, as seen through the cross-sectional view of the semiconductor light emitting element. The first conductivity-type semiconductor layer 1553 is located between the two mesa structures having the second conductivity-type semiconductor layer 1555. In this case, the active layer 1554 in the semiconductor light emitting element has a large area, compared to a semiconductor light emitting element having one mesa structure, thus being capable of increasing luminous efficacy.

Thereafter, as shown in FIG. 15(d), a first conductivity-type electrode 1553 is conductively connected to the first conductivity-type semiconductor layer 1553, and a second conductivity-type electrode 1556 is conductively connected to the second conductivity-type semiconductor layer 1555.

Thereafter, as shown in FIG. 15(e), a passivation layer 1557 surrounding the upper and side surfaces of the semiconductor light emitting elements is formed, and an etching electrode 1512 is formed on a part of the exposed regions of the etching layer 1558. The etching electrode 1512 is used to apply voltage so as to separate the semiconductor light emitting elements from the growth substrate 1510 through electrochemical etching.

Through electrochemical etching, as shown in FIG. 15(f), the etching layer may be divided into a first etching layer 1558a together with the etching protection layer 1559 separated from the growth substrate, and a second etching layer 1558b remaining on the growth substrate. Further, a part of the etching protection layer 1559 may be etched together with the etching layer 1558 depending on the conditions of the etching process. The first etching layer 1558a is separated from the growth substrate by etching, and may thus have an irregularly interface having an uneven surface. For example, the interface may have an irregularly uneven structure having protrusions and depressions. Therefore, the semiconductor light emitting element 1550 according to the present disclosure may have the uneven structure on one surface thereof, and the uneven structure may allow the semiconductor light emitting element 1550 to be assembled in one direction during a subsequent assembly process.

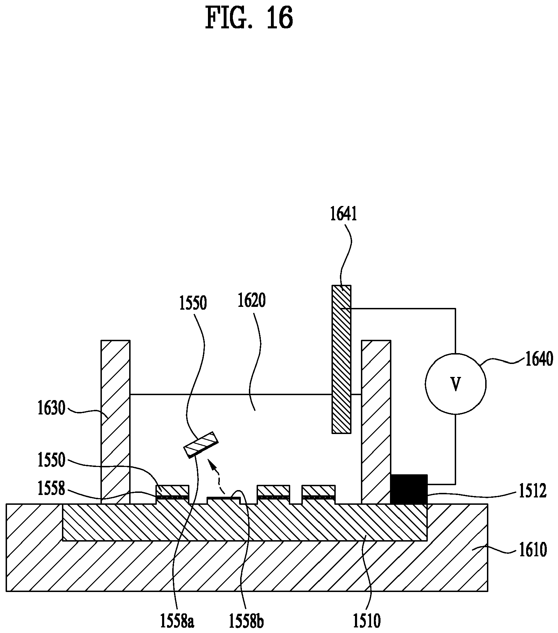

FIG. 16 is a diagram illustrating an electrochemical etching method according to the present disclosure.

As shown in FIG. 16, the growth substrate 1510 on which the semiconductor light emitting elements 1550 including the etching layer 1558 is formed is fixed to a support 1510. Some regions of the growth substrate 1510 are isolated by a beaker-type structure 1630, and the inside of the beaker-type structure is filled with an etching solution 1620. That is, the semiconductor light emitting elements 1550 on the growth substrate 1510 are exposed to the etching solution 1620. The etching electrode 1512 on the growth substrate 1150 is located outside the beaker-type structure 1630. Therefore, as shown in FIG. 16, a voltage difference between the etching electrode 1512 and another electrode 1641 located inside the etching solution 1620 is caused by a voltage application apparatus 164. For example, the voltage application apparatus may apply 0V to the etching electrode 1512, and may apply 15V to the other electrode 1641. Therefore, there may be a corresponding voltage difference between the growth substrate 1510 and the etching solution 1620, and thereby, etching may be further accelerated. Further, the etching solution 1620 may be an oxalic acid aqueous solution, and may etch the semiconductor layer including the etching layer. However, in case of the semiconductor light emitting elements formed on the growth substrate 1510, as shown in FIG. 5(e), the remaining regions of the growth substrate other than the etching layer 1558 are protected by the passivation layer, and thus, the etching layer 1558 is mainly etched.

Since the etching layer 1558 is one region configured to connect the semiconductor light emitting elements 1550 to the growth substrate 1510, when the etching layer 1558 is completely etched, as shown in FIG. 16, the semiconductor light emitting elements including the remaining first etching layer 1558a may be separated from the growth substrate 1510. Further, the second etching layer 1558b may remain on the growth substrate 1510.

Further, the voltage application apparatus 1640 may be operated selectively in a constant voltage mode or in a pulse mode executed to apply voltage. For example, the voltage application apparatus is operated so as to maintain a constant voltage regardless of time during the etching process in the constant voltage mode, and regularly repeats turning-on and turningoff during the etching process in the pulse mode. As will be described later, in the pulse mode, the shape of the uneven structure formed by etching may be controlled depending on an interval between the on time and the off time of the voltage application apparatus.

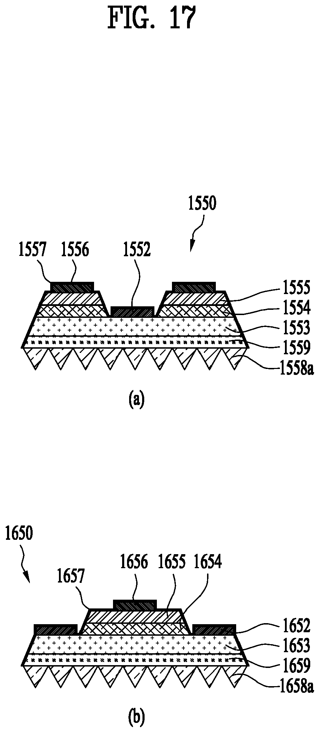

FIG. 17 shows diagrams illustrating semiconductor light emitting elements according to various embodiments of the present disclosure.

FIG. 17(a) illustrates the horizontal semiconductor light emitting element 1550 having two mesa structures. The semiconductor light emitting element 1550 may be prepared by the manufacturing method of FIG. 15, and may include the etching layer 1558a having the uneven structure, the etching protection layer 1559, the first conductivity-type semiconductor layer 1553, the active layer 1554, the second conductivity-type semiconductor layer 1555, the first conductivity-type electrode 1552, the second conductivity-type electrode 1556, and the passivation layer 1557. Here, the etching layer 1558a may function as an assembly blocking layer configured to allow semiconductor light emitting element to be assembled in one direction during the self-assembly process, and the first conductivity-type semiconductor layer 1553, the active layer 1554 and the second conductivity-type semiconductor layer 1555 may function as a general semiconductor light emitting structure.

Meanwhile, FIG. 17(b) illustrates a horizontal semiconductor light emitting element 1650 having one mesa structure. As shown in FIG. 17(b), a second conductivity-type semiconductor layer 1655 may be disposed in the central region of a first conductivity-type semiconductor layer 1653. Further, the semiconductor light emitting element 1650 may include an etching layer 1558a having an uneven structure, an etching protection layer 1559, a first conductivity-type semiconductor layer 1553, an active layer 1554, a second conductivity-type semiconductor layer 1555, a first conductivity-type electrode 1552, a second conductivity-type electrode 1556, and a passivation layer 1557.

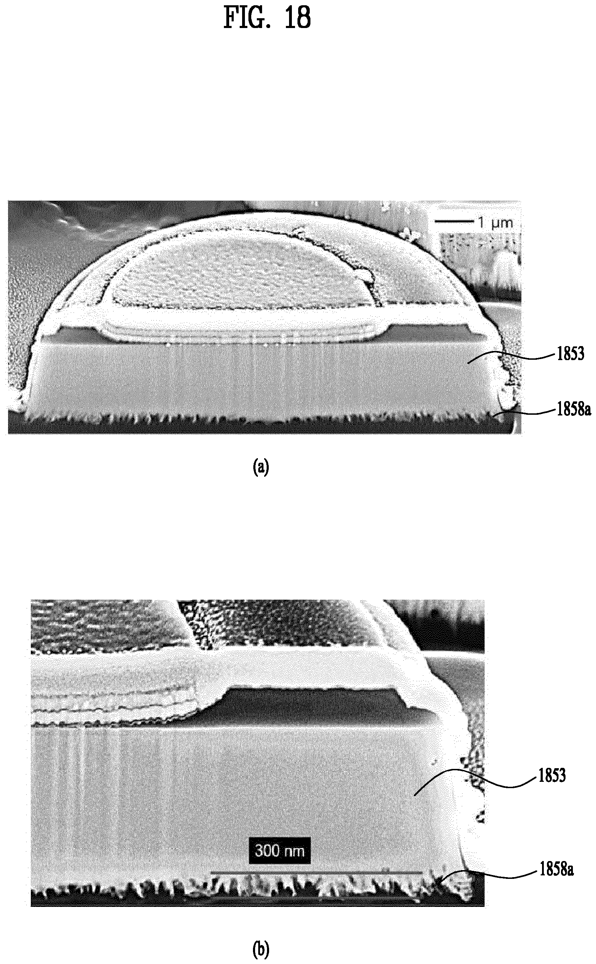

FIG. 18 shows SEM images representing the cross-section of a semiconductor light emitting element including an assembly blocking layer.

As described above, the assembly blocking layer indicates an etching layer remaining on the semiconductor light emitting element by electromechanical etching. As shown in FIG. 18(a), an assembly blocking layer (or an etching layer) 1858a located under a first conductivity-type semiconductor layer 1853 may have an irregularly uneven structure.

FIG. 18(b) is the enlarged SEM image of the assembly blocking layer of FIG. 18(a). It is observed that the assembly blocking layer 1858a located under the first conductivity-type semiconductor layer 1853 have an average surface roughness of about 300 nm. When the surface roughness has a value which is equal to or greater than an effective distance on which DEP force acts, the semiconductor light emitting element is not assembled through the surface thereof having the surface roughness. For example, at the current level of the self-assembly process in consideration of the size of semiconductor light emitting elements, voltage applied to assembly electrodes, etc., it is difficult to apply DEP force to a distance which is equal to or greater than about 200 nm. Therefore, it is difficult to assemble the semiconductor light emitting element of FIG. 18(b) with an assembly recess of an assembly substrate in the direction of the etching layer 1858a having the uneven structure.

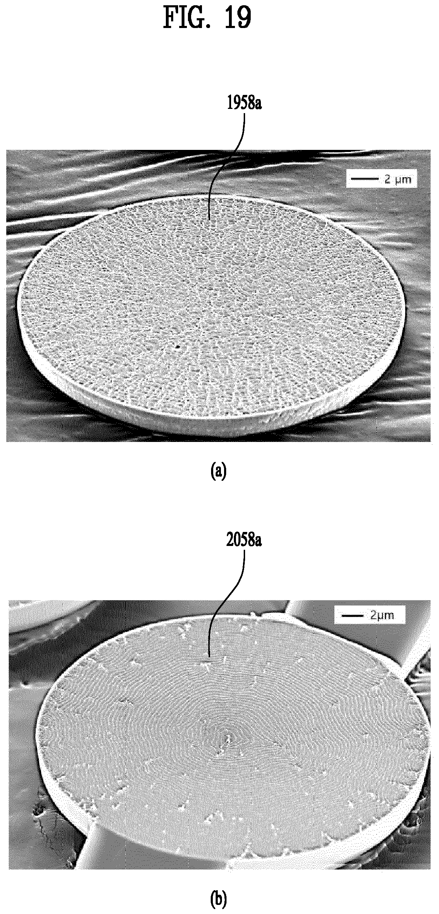

FIG. 19 shows SEM images representing assembly blocking layers of a semiconductor light emitting element formed by electrochemical etching.

Here, the assembly blocking layer indicates an etching layer remaining on the semiconductor light emitting element by electrochemical etching.

FIG. 19(a) is an SEM image of the surface of an etching layer 1958a formed by etching in the constant voltage mode, and FIG. 19(b) is an SEM image of the surface of an etching layer 2058a formed by etching in the pulse mode.

As shown in FIG. 19(a), the etching layer 1958a formed in the constant voltage mode has an uneven structure in which prominences are irregularly disposed towards the center of the etching layer 1958a. On the other hand, it is observed that the etching layer 2058a formed by in the pulse mode, as shown in FIG. 19(b), has an uneven structure disposed in a pattern in which prominences extend to form a plurality of bands in a direction from the center of the surface of the etching layer 1958a towards the edge thereof.

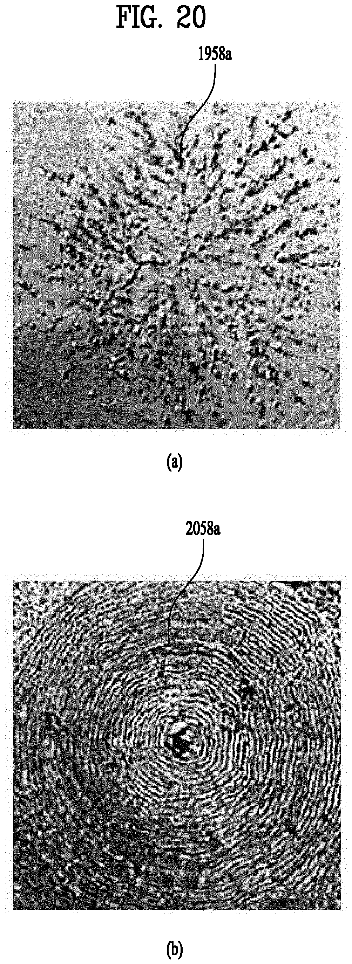

FIG. 20 shows images of the surfaces of the assembly blocking layers of FIG. 19, acquired by a laser microscope.

In FIG. 19(a), the prominences (or protrusions) of the uneven structure are irregularly formed on the surface of the etching layer 1958a but, in FIG. 19(b), the prominences of the uneven structure extend to form the plurality of bands in the direction from the center of the surface of the etching layer 1958a towards the edge thereof, like tree rings. The reason for formation of the tree ring-type bands is that, as there is the interval between the on time and the off time of the voltage application apparatus in the pulse mode, a process in which, when the voltage application apparatus is turned on, etching is started from the edge of the etching layer, and then, when the voltage application apparatus is turned off, etching is stopped is repeated, and thus, the interval between the on time and the off time of the voltage application apparatus is reflected in the pattern. Therefore, the pattern forming the uneven structure may be controlled in the pulse mode, compared to in the constant voltage mode. Since the assembly direction is controlled depending on surface roughness of the uneven structure and the pattern thereof during the self-assembly process, in case that electrochemical etching is performed in the pulse mode, a more precise assembly blocking layer may be formed on a semiconductor light emitting element.

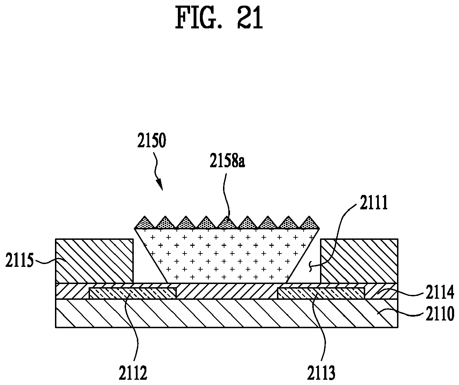

FIG. 21 is a cross-sectional diagram illustrating a semiconductor light emitting element assembled on an assembly substrate by self-assembly.

As shown in FIG. 21, when the self-assembly process is completed, a light emitting element 1150 may be located in an assembly recess 2111 of an assembly substrate. The assembly substrate may include assembly electrodes 2112 and 2113 configured to apply voltage to the substrate 2110, an insulating layer 2114 configured to protect the assembly electrodes 2112 and 2113, and a partition wall 2115 configured to form assembly recesses.

Further, the semiconductor light emitting element 2150 is disposed in the assembly recess 2111 such that a remaining etching layer 2158a faces upwards. As described above, it is difficult to fix an etching layer having a designated surface roughness or more by DEP force, and thus, a semiconductor light emitting element is not assembled with the assembly recess through the corresponding etching layer.

That is, in order to fix the semiconductor light emitting element to the inside of the assembly recess by DEP force, a designated area or more of the semiconductor light emitting element should be located within an effective distance on which DEP force acts but, in case that a contact surface of the element and the assembly recess is very small due to the uneven structure of the etching structure, the surface of the element provided with the uneven structure may be separated from the assembly recess without being fixed thereto, and then, the other surface of the element opposite to the uneven structure may be fixed to the substrate. For example, the other surface of the element has a relatively flat region, as shown in FIG. 21, and this region comes into contact with the bottom surface of the assembly recess 2111.

It is very important to control the semiconductor light emitting element to be assembled in one direction during the self-assembly process. Since semiconductor light emitting elements form subpixels in a display device and the corresponding display device may be determined as defective even when only one pixel is defective, all of the semiconductor light emitting elements should be assembled in the same direction. Therefore, in case that some semiconductor light emitting elements are erroneously assembled during the self-assembly process in the fluid, the corresponding assembly process may be performed again, and thereby, working time and costs required are increased. Therefore, in case that the semiconductor light emitting elements according to the present disclosure are assembled in only one direction, assembly accuracy and assembly time may be greatly shortened.

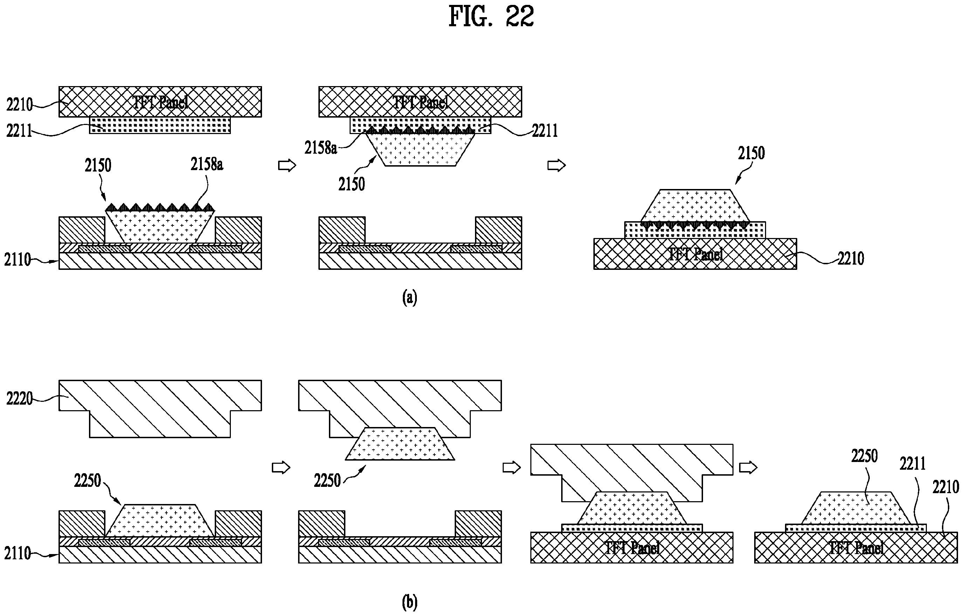

FIG. 22 shows cross-sectional diagrams illustrating a process of transferring the semiconductor light emitting element assembled on the assembly substrate to a wiring substrate.

FIG. 22(a) illustrates a process of transferring the semiconductor light emitting element 2150 assembled on the substrate 2110 according to the present disclosure to a wiring substrate 2210. An adhesive layer 2211 configured to fix the semiconductor light emitting element is formed on the wiring substrate 2210. Further, the semiconductor light emitting element 2150 assembled on the substrate 2110 is configured such that the assembly blocking layer 2158a faces upwards. Therefore, as shown in FIG. 22(a), the adhesive layer 2211 comes into contact with the assembly blocking layer 2150, and thereafter, when the semiconductor light emitting element 2150 is transferred to the wiring substrate 2210, the other surface of the semiconductor light emitting element 2150 not provided with the assembly blocking layer 2158a is exposed. It may be assumed that the semiconductor light emitting element 2150 of FIG. 21(a) has the same structure as the semiconductor light emitting element 1550 of FIG. 17(a), and conductivity-type electrodes may be located on the other surface of the element opposite to the assembly blocking layer 2158a. Therefore, during the subsequent metallization process, a passivation layer may be removed from some regions, and the conductivity-type electrodes and wiring electrodes may be conductively connected to each other. That is, the element may be disposed such that the conductivity-type electrodes thereof are positioned on the upper portion of the element through one transfer process from the assembly substrate 2110 to the wiring substrate 2210, and the metallization process may then be immediately performed.

On the other hand, FIG. 22(a) illustrates a process of transferring a semiconductor light emitting element 2250 having no assembly blocking layer, which is assembled on a substrate 2110, to a temporary substrate 2220 and then transferring the semiconductor light emitting element 2250 on the temporary substrate 2220 to a wiring substrate 2210. It is assumed that the semiconductor light emitting element 2250 having no assembly blocking layer has the same structure the semiconductor light emitting element 1550 of FIG. 17(a) except for an etching layer and an etching protection layer. Therefore, a first conductivity-type semiconductor layer region on which conductivity-type electrodes are not located may be assembled on the assembly substrate.

Therefore, in order to locate the conductivity-type electrodes of the semiconductor light emitting element 2250 on the wiring substrate 2210 such that the conductivity-type electrodes thereof are positioned on the upper portion of the element, it is difficult to directly transfer the element from the assembly substrate 2110 to the wiring substrate 2210, and thus, an additional process of transferring the element to the temporary substrate 2220 is required. The temporary substrate 2220 includes an adhesive protrusion, and the semiconductor light emitting element 2250 is transferred to the protrusion and is then transferred to the wiring substrate 2210.

Therefore, compared to FIG. 22(a), in the process shown in FIG. 22(b), transfer to the temporary substrate 2220 is further performed, and thus, a process time may be lengthened. That is, the semiconductor light emitting element according to the present disclosure may shorten a time taken to perform transfer of the element to the wiring substrate 2210 compared to the conventional semiconductor light emitting element.

The above description is merely illustrative of the technical idea of the present disclosure. Those of ordinary skill in the art to which the present disclosure pertains will be able to make various modifications and variations without departing from the essential characteristics of the present disclosure.

Therefore, embodiments disclosed in the present disclosure are not intended to limit the technical idea of the present disclosure, but to describe, and the scope of the technical idea of the present disclosure is not limited by such embodiments.

The scope of protection of the present disclosure should be interpreted by the claims below, and all technical ideas within the scope equivalent thereto should be construed as being included in the scope of the present disclosure.

## Claims

1. A manufacturing method of a display device, the manufacturing method comprising:
forming a semiconductor light emitting element comprising an assembly blocking layer formed on one surface thereof;
preparing an assembly substrate comprising an assembly recess configured such that the semiconductor light emitting element is assembled therewith;
putting the semiconductor light emitting element into a chamber filled with a fluid;
locating the assembly substrate on an upper surface of the chamber, and assembling the semiconductor light emitting element with the assembly recess of the assembly substrate using a magnetic field and an electric field; and
transferring the semiconductor light emitting element assembled on the assembly substrate to a wiring substrate.

2. The manufacturing method of claim 1, wherein the forming the semiconductor light emitting element comprises:
forming a stack structure by sequentially stacking an etching layer, an etching protection layer, a first conductivity-type semiconductor layer, an active layer and a second conductivity-type semiconductor layer on a growth substrate;
performing isolation to expose some regions of the etching layer of the stack structure, in order to individually define the semiconductor light emitting element;
forming conductivity-type electrodes conductively connected to the first conductivity-type semiconductor layer and the second conductivity-type semiconductor layer of the isolated semiconductor light emitting element;
forming a passivation layer configured to surround an outer surface of the semiconductor light emitting element;
forming an etching electrode on a part of the exposed regions of the etching layer on the growth substrate; and
separating the semiconductor light emitting element from the growth substrate through electrochemical etching, and forming an assembly blocking layer on a surface of the semiconductor light emitting element separated from the growth substrate.

3. The manufacturing method of claim 2, wherein the forming the assembly blocking layer comprises separating the etching layer into a first etching layer remaining on a lower surface of the etching protection layer and a second etching layer remaining on the growth substrate through the electrochemical etching.

4. The manufacturing method of claim 3, wherein:
the assembly blocking layer comprises the first etching layer; and
the first etching layer has an uneven structure.

5. The manufacturing method of claim 4, wherein an average surface roughness value of the assembly blocking layer is equal to or greater than an effective distance value of dielectrophoresis force acting in the assembling the semiconductor light emitting element with the assembly recess.

6. The manufacturing method of claim 5, wherein the forming the assembly blocking layer comprises forming the uneven structure of the assembly blocking layer in a specific pattern by applying a pulse signal to the etching electrode.

7. The manufacturing method of claim 6, wherein the pattern is configured such that prominences of the uneven structure extend to form a plurality of bands in a direction from a center of a surface of the assembly blocking layer towards an edge thereof.

8. The manufacturing method of claim 7, wherein a distance between the plurality of bands is determined depending on an on time and an off time of the pulse signal.

9. The manufacturing method of claim 1, wherein the assembling the semiconductor light emitting element with the assembly recess comprises placing a remaining surface of the semiconductor light emitting element opposite to the surface thereof provided with the assembly blocking layer formed thereon on the assembly recess.

10. The manufacturing method of claim 2, wherein the etching layer and the etching protection layer are an identical semiconductor type with the second conductivity-type semiconductor layer.

11. The manufacturing method of claim 2, wherein a concentration of impurities in the etching layer is greater than a concentration of impurities in the etching protection layer.

12. The manufacturing method of claim 2, wherein the forming the stack structure comprises forming a buffer layer between the growth substrate and the etching layer.

13. A display device comprising:
a substrate;
an adhesive layer located on the substrate; and
a semiconductor light emitting element located on the adhesive layer and configured such that a contact surface between the semiconductor light emitting element and the adhesive layer has an uneven structure,
wherein the uneven structure is configured such that prominences of the uneven structure extend to form a plurality of bands in a direction from a center of the contact surface towards an edge thereof.

14. The display device of claim 13, wherein the semiconductor light emitting element comprises a semiconductor light emitting structure comprising a first conductivity-type semiconductor layer, an active layer and a second conductivity-type semiconductor layer, and the uneven structure located under the first conductivity-type semiconductor layer,
wherein the uneven structure comprises a first region and a second region disposed between the first region and the first conductivity-type semiconductor layer, and a concentration of impurities in the first region is greater than a concentration of impurities in the second region.

15. The display device of claim 14, wherein an average surface roughness value of the uneven structure is equal to or greater than an effective distance value of dielectrophoresis force occurring during a self-assembly process.
